# DEMANDE DE BREVET EUROPEEN

(11) **EP 2 784 705 A1**
(43) Date de publication de la demande: **01.10.2014**
(21) Numéro de dépôt: 14161241.6
(22) Date de dépôt: 24.03.2014
(51) Int. Cl.: G06F 17/50

(54) **Procédé de génération de fichiers de modélisation d'un flot de conception de circuit intégré, programme d'ordinateur et système correspondants**

(30) Priorité: 26.03.2013 FR 1352721
(71) Demandeur: Commissariat à l'Énergie Atomique et aux Énergies Alternatives, 75015 Paris (FR)
(72) Inventeur: Cibrario, Gérald, 38500 La Buisse (FR)
(74) Mandataire: Bonnet, Michel

(57) **Abrégé**

Ce procédé de génération de fichiers (60) de modélisation d'un flot de conception de circuit intégré à plusieurs couches interconnectées entre elles comporte les étapes suivantes : fourniture (100, 102) de fichiers de référence (54) modélisant un flot de conception de référence incluant un ensemble prédéterminé (50, 52) de dispositifs de connexion tridimensionnelle et de règles de dessins de référence ; fourniture (104) d'un manuel (58) de règles de dessins relatives au flot de conception souhaité ; génération (106) des fichiers (60) de modélisation du flot de conception souhaité à partir des fichiers de référence (54) et du manuel (58) de règles de dessins fourni.

Les dispositifs de connexion tridimensionnelle souhaités (56) étant tous choisis parmi les dispositifs de connexion de référence, l'étape (106) de génération des fichiers (60) de modélisation du flot de conception souhaité comporte un filtrage des fichiers de référence (54) par suppression de toutes données relatives à des dispositifs de connexion non choisis et par précision des règles de dessins de référence (50) à l'aide du manuel (58) de règles de dessins fourni.

## Description

Procédé de génération de fichiers de modélisation d'un flot de conception de circuit intégré, programme d'ordinateur et système correspondants

La présente invention concerne un procédé de génération de fichiers de modélisation d'un flot de conception de circuit intégré, pour un circuit intégré à plusieurs couches interconnectées entre elles par des dispositifs de connexion tridimensionnelle. Elle concerne également un programme d'ordinateur et un système correspondants.

D'une façon générale, à partir d'une technologie tridimensionnelle donnée, à partir de composants et couches souhaités dans le circuit intégré à concevoir et à partir d'un manuel de règles de dessins, il est connu d'engendrer, à l'aide de logiciels dédiés, les fichiers de modélisation du flot de conception du circuit intégré souhaité.

Par « fichiers de modélisation d'un flot de conception de circuit intégré », on entend l'ensemble de fichiers généralement qualifié de PDK (de l'anglais « Process Design Kit ») et comportant :
- les bibliothèques logicielles de cellules fonctionnelles standard,
- les règles de dessins du circuit intégré,
- des modèles de simulation de composant spécifiques du circuit intégré, et
- les informations d'agencement (de l'anglais « layout »).

Par « règles de dessins », on entend un ensemble de paramètres recommandés associés à des contraintes d'agencement des composants et couches utilisés lors de la conception du circuit intégré. Ces règles de dessins font l'objet de vérifications DRC (de l'anglais « Design Rules Checking ») dans le flot de conception à l'aide de logiciels adaptés et connus. Elles concernent généralement au moins des valeurs de largeurs (i.e. largeurs minimales de composants dans le dessin), d'espacements (i.e. espacements minimaux entre composants dans le dessin) ou de couverture d'un composant par un autre entre deux couches (i.e. marge de couverture minimale d'un composant par un autre dans le dessin). Elles sont rassemblées en un ou plusieurs fichiers de description, le tout étant qualifié de « manuel de règles de dessins » ou DRM (de l'anglais « Design Rules Manual »), fourni par un spécialiste, oeuvrant en amont du concepteur de circuit intégré, pour vérifier le bon agencement des masques à réaliser. Ce spécialiste est généralement qualifié de technologue. Les règles de dessins sont propres à une technologie de fabrication donnée et forment un ensemble de restrictions de géométrie et de connectivité assurant des marges suffisantes d'erreurs prenant en compte les variabilités de fabrication des différents composants du circuit imprimé.

Dans ce schéma de conception de circuits intégrés, chaque fois qu'un nouveau circuit intégré doit être conçu, le technologue doit fournir un nouveau DRM propre à ce nouveau circuit et c'est à partir de ce nouveau DRM qu'un nouveau PDK peut être créé. Il semble avantageux, pour des raisons de gain de temps, de pouvoir utiliser des PDK déjà élaborés pour en construire de nouveaux sur la base de nouveaux DRM fournis par le technologue.

L'invention s'applique ainsi plus particulièrement à la génération de fichiers de modélisation d'un flot de conception souhaité, ce flot de conception étant celui d'un circuit intégré à plusieurs couches interconnectées entre elles par des dispositifs de connexion tridimensionnelle souhaités, comportant les étapes suivantes :
- fourniture de fichiers de référence modélisant un flot de conception de référence incluant un ensemble prédéterminé de dispositifs de connexion tridimensionnelle et de règles de dessins de référence,
- fourniture d'un manuel de règles de dessins relatives au flot de conception souhaité,
- génération des fichiers de modélisation du flot de conception souhaité à partir des fichiers de référence et du manuel de règles de dessins fourni.

Le PDK déjà élaboré est donc considéré comme un PDK de référence à partir duquel on construit le nouveau PDK sur la base d'un nouveau DRM. Mais cette opération n'est pas simple. En effet, la technologie étant appelée à évoluer, le PDK de référence devient rapidement obsolète et il est alors nécessaire d'ajouter manuellement des mises à jour. De plus, selon l'approche généralement envisagée, c'est un PDK de référence minimaliste qui est retenu, l'obtention d'un nouveau PDK sur la base d'un nouveau DRM et à partir du PDK de référence se faisant alors par des ajouts supplémentaires relatifs aux spécificités du nouveau PDK souhaité.

Tout cela implique l'ajout au cas par cas de fonctionnalités additionnelles sous la forme de « add-ons ». Le gain de temps et la simplification souhaités, résultant de l'exploitation d'un PDK de référence minimaliste pour la génération d'un nouveau PDK, restent en fait limités voire discutables. Cette approche n'est donc pas satisfaisante.

Il peut ainsi être souhaité de prévoir un procédé de génération de fichiers de modélisation d'un flot de conception de circuit intégré qui permette de s'affranchir d'au moins une partie des problèmes et contraintes précités.

Il est donc proposé un procédé de génération de fichiers de modélisation d'un flot de conception souhaité, ce flot de conception étant celui d'un circuit intégré à plusieurs couches interconnectées entre elles par des dispositifs de connexion tridimensionnelle souhaités, comportant les étapes suivantes :
- fourniture de fichiers de référence modélisant un flot de conception de référence incluant un ensemble prédéterminé de dispositifs de connexion tridimensionnelle et de règles de dessins de référence,
- fourniture d'un manuel de règles de dessins relatives au flot de conception souhaité,
- génération des fichiers de modélisation du flot de conception souhaité à partir des fichiers de référence et du manuel de règles de dessins fourni,
dans lequel, les dispositifs de connexion tridimensionnelle souhaités étant tous choisis parmi les dispositifs de connexion tridimensionnelle du flot de conception de référence, l'étape de génération des fichiers de modélisation du flot de conception souhaité comporte un filtrage des fichiers de référence par suppression de toutes données relatives à des dispositifs de connexion tridimensionnelle non choisis et par précision des règles de dessins de référence à l'aide du manuel de règles de dessins fourni.

Ainsi, le procédé proposé permet de ne pas avoir à recourir à des add-ons. Il présente en outre d'autres avantages. En premier lieu, il permet, à partir d'une technologie donnée, notamment en dispositifs de connexion tridimensionnelle, de construire un PDK de référence complet puis de proposer d'adapter ce PDK de référence complet aux besoins spécifiques exprimés dans un DRM client par simple filtrage, c'est-à-dire par sélection uniquement des données relatives aux dispositifs de connexion tridimensionnelle choisis par le client en supprimant les autres et par précision de règles de dessins déjà élaborées en fonction des besoins du client. Le détenteur de la technologie considérée en garde ainsi une maîtrise tout en pouvant la partager. En second lieu, l'adaptation du PDK de référence par un filtrage tel que défini précédemment est bien plus simple à réaliser qu'une adaptation par add-ons.

De façon optionnelle, les dispositifs de connexion tridimensionnelle de référence comportent au moins l'un des éléments de l'ensemble constitué de micro-bumps, de landing micro bumps, de front side UBMs, de plots, de vias TSV, de back side UBMs, de pillars et de landing pillars.

De façon optionnelle également, la fourniture de fichiers de référence modélisant un flot de conception de référence comporte la constitution d'un manuel de règles de dessins de référence relatives au flot de conception de référence à partir d'une offre technologique de référence comportant tous les dispositifs de connexion tridimensionnelle de référence et la génération, à partir de ce manuel de règles de dessins de référence, d'un fichier descriptif des dispositifs de connexion tridimensionnelle de référence.

De façon optionnelle également, les règles de dessins du manuel de règles de dessins de référence sont décrites avec au moins des valeurs minimales, nominales et maximales pour chaque niveau de l'offre technologique de référence.

De façon optionnelle également, les fichiers de référence modélisant le flot de conception de référence sont constitués à partir du manuel de règles de dessins de référence sur la base des valeurs nominales, en excluant les valeurs minimales et maximales.

De façon optionnelle également, l'étape de génération des fichiers de modélisation du flot de conception souhaité comporte les six phases suivantes :
- vérification de syntaxe des fichiers de référence modélisant le flot de conception de référence,
- enregistrement de données de description relatives aux dispositifs de connexion tridimensionnelle souhaités et choisis,
- interprétation des règles de dessins relatives au flot de conception souhaité,
- constitution des fichiers de modélisation du flot de conception souhaité par filtrage des fichiers de référence modélisant le flot de conception de référence,
- compilation d'un fichier technologique et création d'une bibliothèque logicielle parmi les fichiers de modélisation du flot de conception souhaité, et
- construction d'une arborescence des fichiers de modélisation du flot de conception souhaité.

Il est en outre proposé un programme d'ordinateur téléchargeable depuis un réseau de communication et/ou enregistré sur un support lisible par ordinateur et/ou exécutable par un processeur, comprenant des instructions pour l'exécution des étapes d'un procédé de génération de fichiers de modélisation d'un flot de conception de circuit intégré selon l'invention, lorsque ledit programme est exécuté sur un ordinateur.

Il est en outre proposé un système de génération de fichiers de modélisation d'un flot de conception souhaité, ce flot de conception étant celui d'un circuit intégré à plusieurs couches interconnectées entre elles par des dispositifs de connexion tridimensionnelle souhaités, comportant :
- des moyens de stockage de fichiers de référence modélisant un flot de conception de référence incluant un ensemble prédéterminé de dispositifs de connexion tridimensionnelle et de règles de dessins de référence,
- des moyens de stockage d'un manuel de règles de dessins relatives au flot de conception souhaité incluant des dispositifs de connexion tridimensionnelle souhaités,
- un processeur ayant accès aux moyens de stockage et générateur de fichiers de modélisation du flot de conception souhaité à partir des fichiers de référence et du manuel de règles de dessins fourni,
dans lequel, les dispositifs de connexion tridimensionnelle souhaités étant tous choisis parmi les dispositifs de connexion tridimensionnelle du flot de conception de référence, le système comporte des moyens de filtrage des fichiers de référence par suppression de toutes données relatives à des dispositifs de connexion tridimensionnelle non choisis et par précision des règles de dessins de référence à l'aide du manuel de règles de dessins fourni, ces moyens de filtrage étant exécutables par le processeur pour la génération des fichiers de modélisation du flot de conception souhaité.

De façon optionnelle, un système de génération de fichiers de modélisation d'un flot de conception de circuit intégré selon l'invention peut comporter une interface de saisie, exécutable par le processeur, pour la fourniture par un utilisateur d'au moins une partie des règles de dessins relatives au flot de conception souhaité incluant les dispositifs de connexion tridimensionnelle souhaités, cette interface de saisie comportant :
- une zone de sélection de dispositifs de connexion tridimensionnelle souhaités dans l'ensemble prédéterminé de dispositifs de connexion tridimensionnelle du flot de conception de référence,
- une zone de saisie de valeurs de règles de dessins relatives aux dispositifs de connexion tridimensionnelle sélectionnés.

De façon optionnelle également, l'interface de saisie peut être configurée pour une saisie d'informations issues du manuel de règles de dessins relatives au flot de conception souhaité et le complétant.

L'invention sera mieux comprise à l'aide de la description qui va suivre, donnée uniquement à titre d'exemple et faite en se référant aux dessins annexés dans lesquels :
- la figure 1 représente schématiquement la structure générale d'un exemple d'offre technologique de référence en dispositifs de connexion tridimensionnelle,
- la figure 2 illustre les étapes successives d'un procédé de génération de fichiers de modélisation d'un flot de conception de circuit intégré, selon un mode de réalisation de l'invention, exécuté sur la base de l'offre technologique de la figure 1, et
- la figure 3 représente schématiquement la structure générale d'un système informatique de mise en oeuvre du procédé de la figure 2.

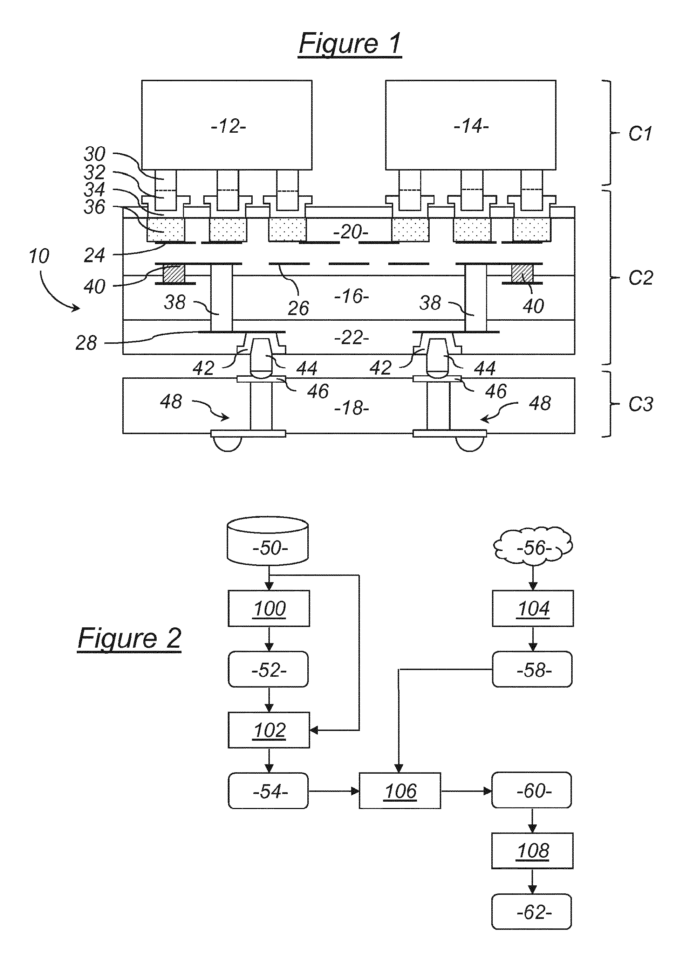

Le circuit intégré 10 à trois couches représenté schématiquement sur la figure 1 comporte, à titre d'exemple purement illustratif et non limitatif, deux puces électroniques supérieures 12 et 14 en silicium sur une première couche C1, une puce électronique d'interposition 16 également en silicium sur une deuxième couche C2 et un substrat 18 sur une troisième couche C3. La deuxième couche C2 comporte également, au-dessus et en dessous de la puce électronique d'interposition 16, deux couches isolantes 20 et 22 dans lesquelles sont imprimées des pistes métalliques 24, 26 (pour la couche isolante supérieure 20) et 28 (pour la couche isolante inférieure 22). Ce circuit intégré 10 constitue une offre technologique de référence relative à un circuit intégré à plusieurs couches interconnectées entre elles par des dispositifs de connexion tridimensionnelle de référence.

En particulier, entre les première et deuxième couches C1 et C2, des dispositifs de connexion tridimensionnelle de référence sont proposés. Plus précisément, entre la puce électronique supérieure 12 de la couche C1 et la piste métallique 24 de la couche isolante supérieure 20 de la couche C2, trois micro-boîtiers de raccordement 30, généralement qualifiés en terminologie anglo-saxonne de « micro-bumps », sont prolongés respectivement par des portions inférieures 32 de boîtiers de raccordement, généralement qualifiées en terminologie anglo-saxonne de « landing micro-bumps », elles-mêmes disposées respectivement sur trois pièces métallisées 34 d'accueil avant de boîtier de raccordement, généralement qualifiées en terminologie anglo-saxonne de « front side UBMs » (UBM pour « Under Bump Metallurgy »). Ces trois pièces métallisées 34 d'accueil de boîtier de raccordement sont intégrées en partie supérieure de la couche isolante supérieure 20 et disposées respectivement sur trois plots 36 de raccordement à la piste métallique 24. Entre la puce électronique supérieure 14 de la couche C1 et la piste métallique 24 de la couche isolante supérieure 20 de la couche C2, les mêmes dispositifs de connexion tridimensionnelle sont proposés.

En particulier également, à l'intérieur de la deuxième couche C2, entre la couche isolante supérieure 20 et la couche isolante inférieure 22, des dispositifs de connexion tridimensionnelle de référence sont proposés. Plus précisément, deux vias traversants 38 de type TSV (pour « Through Silicon Via ») sont disposés entre la piste métallique 26 de la couche isolante supérieure 20 et la piste métallique 28 de la couche isolante inférieure 22. On notera par ailleurs que deux transistors 40 sont intégrés à titre d'exemple dans la puce électronique d'interposition 16 et raccordés à la piste métallique 26.

En particulier également, entre les deuxième et troisième couches C2 et C3, des dispositifs de connexion tridimensionnelle de référence sont proposés. Plus précisément, entre la piste métallique 28 de la couche isolante inférieure 22 de la couche C2 et le substrat 18, deux pièces métallisées 42 d'accueil arrière de boîtier de raccordement, généralement qualifiées en terminologie anglo-saxonne de « back side UBMs », sont intégrées dans la couche isolante inférieure 22 et raccordées à la piste métallique 28. Contre ces deux pièces métallisées d'accueil arrière 42 sont respectivement disposés, entre les deuxième et troisième couches C2 et C3, deux piliers 44, généralement qualifiés en terminologie anglo-saxonne de « pillars » et prenant habituellement la forme de billes de connexion. Ces deux piliers 44 reposent respectivement sur deux pièces 46 d'accueil de piliers, généralement qualifiées en terminologie anglo-saxonne de « landing pillars », intégrées en partie supérieure du substrat 18. Enfin, à travers l'épaisseur du substrat 18, des dispositifs de connexion supplémentaires, portant la référence générale 48, permettent de relier les deux pièces 46 d'accueil de piliers à des conducteurs situés en face inférieure du substrat 18.

Ainsi, un ensemble prédéterminé de dispositifs de connexion tridimensionnelle de référence est constitué. Dans l'exemple illustré par la figure 1, il comporte notamment les micro-bumps 30, les landing micro bumps 32, les front side UBMs 34, les plots 36, les vias TSV 38, les back side UBMs 42, les pillars 44 et les landing pillars 46. Dans la succession d'étapes illustrée sur la figure 2, il est défini par au moins un fichier stocké en mémoire, ce fichier portant la référence 52.

Au cours d'une étape 100 du procédé de génération de fichiers de modélisation d'un flot de conception illustré sur la figure 2, le fichier 52 est généré à partir d'un manuel préexistant de règles de dessins de référence, dit DRM de référence 50, associé au circuit intégré 10 et décrivant complètement ses règles de dessins.

En pratique, le fichier 52 de description des dispositifs de connexion tridimensionnelle de référence doit contenir la liste de tous les dispositifs de connexion tridimensionnelle qui sont prélablement identifiés dans le DRM de référence 50. Chaque descriptif de dispositif de connexion tridimensionnelle de référence peut par exemple contenir les données suivantes:
- son nom,
- la liste des niveaux le constituant,
- le nom de son fichier PCell (pour « Parameterized Cell ») de cellules paramétrables,
- le nom de son fichier CDF (pour « Component Description Format »),
- le nom de la cellule créée pour le layout, c'est-à-dire pour les informations d'agencement.

La syntaxe pour chaque dispositif de connexion tridimensionnelle de référence est par exemple la suivante (exemple donné pour un via TSV) :
*#Device TSV*
*layersName b1tsv, b1rdl1, f1lne0*
*filePcellName pc_TSV.il*
*fileCdfName pc_TSV.cdf*
*cellName PC_TSV*

La constitution du DRM de référence 50 et la génération 100 du fichier 52 relèvent de méthodes bien connues et ne seront pas détaillées. Il convient cependant de noter qu'avantageusement, contrairement à un DRM conventionnel, dans lequel pour chaque niveau (de l'anglais « layer ») des règles de dessins sont décrites avec des valeurs minimales, le DRM de référence 50 présente pour chaque règle de dessin une plage de valeurs plus ou moins risquées, telles que des valeurs minimales, nominales, maximales, etc. Par exemple, pour le niveau *b1tsv* d'un via TSV 38, une table de règles de dessins peut être définie de la façon suivante :

| Règle | Min | Rran | Sran | Nom | Imp | Max |
|---|---|---|---|---|---|---|
| *b1tsv* width | 30 | 30-40 | 40-100 | 60 | - | 100 |
| *b1tsv* space | 30 | 30-40 | > 40 | 60 | - | - |
| *b1tsv* enclosure / *f1lne0* | 3 | 3-5 | > 5 | 10 | - | - |
| *b1tsv* shape | 16 | - | - | 32 | - | 64 |

Dans cette table de règles de dessins, la colonne « Min » concerne les valeurs minimales, la colonne « Nom » concerne les valeurs nominales, la colonne « Max » concerne les valeurs maximales, la colonne « Imp » concerne des valeurs imposées et les colonnes « Rran » et « Sran » concernent des plages de valeurs à risques prédéterminés.

Au cours d'une étape 102, un ensemble de fichiers de référence modélisant un flot de conception de référence complet pour l'offre technologique de référence illustrée sur la figure 1, dit PDK de référence 54, est constitué à partir du DRM de référence 50 et du fichier 52. Il convient de noter que le PDK de référence 54 contient tous les dispositifs de connexion tridimensionnelle du DRM de référence 50 décrits dans le fichier 52 mais ne reprend que les valeurs nominales de leurs règles de dessins pour la vérification DRC.

Afin de garder une certaine souplesse technologique, plusieurs fichiers contenus dans le PDK de référence 54 peuvent être personnalisés pour rester flexibles à toutes les demandes. C'est en particulier le cas du fichier des données de vérifications DRC qui, comme indiqué précédemment, reprend les valeurs nominales des règles de dessins du DRM de référence 50. Etant donné que ces règles sont appelées à être modifiées selon les besoins d'un flot de conception souhaité, pour savoir à quel dispositif de connexion tridimensionnelle une règle est associée, le nom du dispositif concerné est précisé comme argument. Par exemple :
*set b1rdl1_width_routing 60 ;#TSV*

Cette instruction permet de sélectionner la règle *b1rdl1_width_routing* relative au dispositif de connexion tridimensionnelle TSV et de l'ajuster à une valeur finale.

Les étapes 100 et 102 n'ont besoin d'être répétées que lorsque l'offre technologique de référence est modifiée dans le DRM de référence 50 de manière à adapter le fichier 52 et le PDK de référence 54 à ces modifications.

Indépendamment de l'exécution de ces étapes, un ensemble de dispositifs de connexion souhaités par un utilisateur est choisi parmi les dispositifs de l'ensemble prédéterminé de dispositifs de connexion tridimensionnelle de référence pour la conception d'un circuit intégré à plusieurs couches comportant en outre d'autres éléments fonctionnels souhaités. Cet ensemble de dispositifs de connexion souhaités est choisi par exemple au cours de réunions. Le choix retenu est illustré sur la figure 2 par la référence 56. A partir des dispositifs de connexion choisis, des autres éléments fonctionnels souhaités pour le circuit intégré à concevoir et du PDK de référence 54, le procédé illustré sur la figure 2 vise à fournir des fichiers de modélisation d'un flot de conception relatif au circuit intégré à concevoir.

Ainsi, au cours d'une étape 104, un manuel de règles de dessins relatives au flot de conception souhaité, dit DRM client 58, est constitué en fonction du choix établi 56. La constitution 104 du DRM client 58 relève, comme celle du DRM de référence 50, d'une méthode bien connue qui ne sera pas détaillée. Il convient cependant de noter que contrairement au DRM de référence 50, le DRM client 58 est tout à fait conventionnel, de sorte que pour chaque niveau les règles de dessins sont décrites avec des valeurs minimales à respecter.

Au cours d'une étape 106 de génération d'un ensemble de fichiers de modélisation du flot de conception souhaité, dit PDK client 60, à partir du PDK de référence 54 et du DRM client 58, le PDK de référence 54 est filtré par suppression de toutes données relatives à des dispositifs de connexion tridimensionnelle non choisis et par précision des règles de dessins de référence à l'aide du DRM client 58. Il résulte de ce filtrage un PDK allégé qui forme alors le PDK client 60.

Plus précisément, au cours de cette étape 106, une première phase consiste à vérifier la syntaxe de certains des différents fichiers du PDK de référence 54 comme par exemple le fichier technologique pour la déclaration des niveaux, le fichier de calibre pour la vérification des règles de dessins, etc.

Une deuxième phase consiste à enregistrer toutes les données contenues dans les fichiers descriptifs relatifs aux dispositifs de connexion tridimensionnels choisis 56 pour la construction des cellules paramétrables dans un premier temps (fichier de contraintes) et pour la description des dispositifs de connexion choisis dans un second temps (fichier catalogue 3D).

Une troisième phase consiste à interpréter toutes les valeurs de règles de dessins du DRM client 58 afin de s'assurer que toutes les contraintes décrites dans les fichiers précités (fichier de contraintes et fichier catalogue 3D) sont bien respectées. Le déroulement de cette phase est bien connu de l'homme du métier et ne sera pas détaillée.

Une quatrième phase consiste à constituer concrètement les fichiers du PDK client 60 en prenant en compte la sélection des dispositifs de connexion choisis pour réaliser le filtrage mentionné précédemment, c'est-à-dire supprimer toutes données relatives à des dispositifs de connexion tridimensionnelle non choisis dans l'ensemble prédéterminé 52 et préciser les règles de dessins définies dans le PDK de référence 54 à l'aide de celles qui sont définies dans le DRM client 58. Toutes les informations récoltées à ce stade du procédé permettent de façon connue en soi de déclarer les niveaux d'empilement dans le fichier technologique précité, de construire les cellules paramétrables et d'ajuster la vérification DRC.

Une cinquième phase consiste à compiler le fichier technologique résultant, par exemple à l'aide de l'outil Cadence (marque déposée), afin de créer une composante essentielle du PDK client 60, à savoir sa bibliothèque logicielle technologique. Cette bibliothèque logicielle technologique permet ainsi le dessin des masques à partir du PDK client 60 pour la conception du circuit intégré souhaité.

Enfin, une sixième et dernière phase consiste à construire l'arborescence même du PDK client 60 pour le dessin des masques.

Une dernière étape 108 consiste à concevoir effectivement, à l'aide du fichier PDK client 60, un modèle 62 du circuit intégré souhaité.

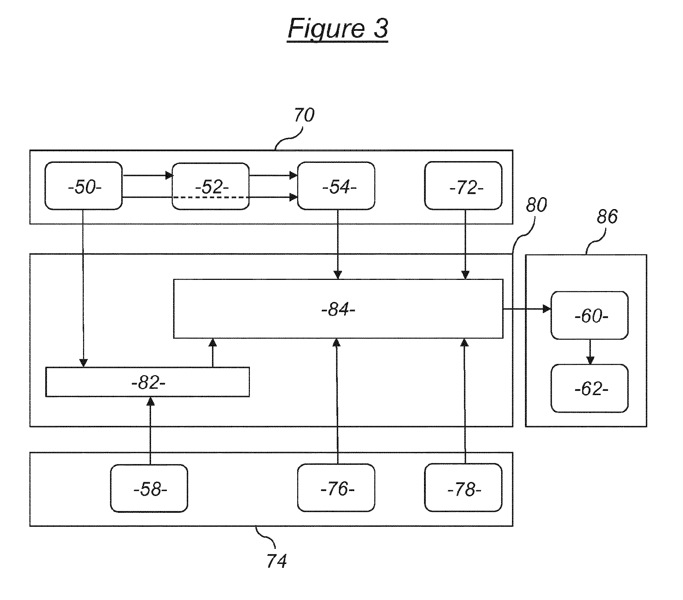

Le procédé de génération de fichiers de modélisation d'un flot de conception de circuit intégré tel que décrit précédemment peut être implémenté à l'aide d'un système automatisé, notamment un système informatique, tel que celui représenté schématiquement sur la figure 3. Ce système comporte de façon connue en soi au moins une unité de traitement associée de façon classique à une mémoire (par exemple une mémoire RAM). L'unité de traitement peut par exemple être mise en oeuvre dans un dispositif informatique tel qu'un ordinateur classique comportant un processeur associé à une ou plusieurs mémoires pour le stockage de fichiers de données et de programmes d'ordinateurs. L'unité de traitement peut alors elle-même être considérée comme formée d'un processeur associé à une mémoire de stockage des instructions qu'il exécute sous forme de programmes d'ordinateurs.

Comme illustré sur la figure 3, le système de génération de fichiers de modélisation d'un flot de conception de circuit intégré peut comporter plusieurs plateformes logicielles éventuellement indépendantes.

Une première plateforme 70 est par exemple dédiée à la génération et au maintien à jour du PDK de référence 54. Elle stocke par exemple en toute indépendance le DRM de référence 50, le fichier descriptif 52 et le PDK de référence 54. Son accès peut être limité uniquement au détenteur de l'offre technologique illustrée sur la figure 1 et servir de base pour la validation des outils qu'il a développés. Elle comporte des instructions de programme d'ordinateur pour l'exécution des étapes 100 et 102.

Elle peut en outre stocker un fichier supplémentaire de contraintes technologiques 72. En effet, certains des dispositifs de connexion tridimensionnelle de l'offre technologique prédéfinie, tels que les vias TSV 38 par exemple, sont construits sur plusieurs niveaux qui doivent respecter des règles de couverture de composants par d'autres entre couches successives. Or les règles de dessins définies dans le DRM de référence 50 peuvent provoquer des erreurs dans les cellules paramétrables lors des vérifications DRC. C'est pourquoi un fichier tel que le fichier de contraintes technologiques 72 peut être prévu, pour contenir toutes les contraintes à respecter. Ces contraintes doivent être rangées par dispositif de connexion. Pour cela, on utilise comme mots clés le nom des règles de dessins correspondantes. Par exemple, on peut utiliser la syntaxe suivante :
*[f1lne0_width]-(2*[b1tsv_enclo_f1lne0])>=[b1tsv_width],*
pour indiquer que la largeur minimale d'une couche donnée - 2 x la couverture par rapport à une autre couche doit respecter la largeur minimale de cette autre couche.

Une deuxième plateforme 74 est par exemple dédiée au stockage de contraintes ou choix définis par le client. Parmi ces contraintes, un fichier 76 de contraintes de résistivité 76 et/ou un fichier 78 d'empreintes du circuit imprimé souhaité peuvent être prévus. Les choix du client sont quant à eux définis dans son DRM client 58, par exemple également stocké dans la plateforme 74.

Une troisième plateforme 80 est dédiée à la génération du PDK client 60 à partir du PDK de référence 54 et de données fournies par le client.

A cet effet, dans un mode de réalisation possible de l'invention, la plateforme 80 présente une interface 82 de saisie d'informations. Les informations saisies grâce à cette interface 82, relatives aux dispositifs de connexion tridimensionnelle à choisir par le client parmi ceux définis dans le fichier descriptif de référence 52 et aux précisions à apporter aux règles de dessins de référence, reprennent en partie les informations contenues dans le DRM client 58 et doivent également permettre de le compléter. Plus précisément, l'interface 82 peut comporter trois sections bien distinctes :
- l'une pour la saisie des répertoires de travail avec notamment le répertoire où doit être stocké le PDK client 60 et le nom de ce PDK, le répertoire de travail pour la partie dessin et gestion des masques,
- une autre pour la sélection des dispositifs de connexion tridimensionnelle à choisir dans l'ensemble prédéterminé des dispositifs de connexion de référence, cette sélection pouvant être saisie à partir des choix définis dans le DRM client 58,
- une autre pour la définition précise des valeurs des règles de dessins nécessaires à la construction des cellules paramétrables ainsi qu'à la validation DRC.

La plateforme 80 comporte enfin un générateur logiciel 84 de fichier PDK client 60 à partir du fichier PDK de référence 54 et des informations saisies à l'aide de l'interface 82. Ce générateur logiciel 84 comporte des instructions de programme d'ordinateur pour l'exécution des six phases de l'étape 106. Une interface de débogage peut être prévue pour suivre l'évolution de ces différentes phases.

Enfin, une quatrième plateforme 86 est dédiée à la conception du modèle 62 de circuit intégré souhaité par le client. Elle comporte des instructions de programme d'ordinateur pour l'exécution de l'étape 108.

Le système de génération de fichiers de modélisation d'un flot de conception de circuit intégré tel qu'illustré sur la figure 3 comporte ainsi fonctionnellement quatre plateformes logicielles pouvant se présenter sous la forme de quatre programmes d'ordinateurs ou quatre fonctions d'un même programme d'ordinateur. On notera en effet que les plateformes logicielles 70, 74, 80 et 86 sont présentées comme distinctes, mais cette distinction est purement fonctionnelle. Elles pourraient tout aussi bien être regroupées selon toutes les combinaisons possibles en un ou plusieurs logiciels plus ou moins indépendants les uns des autres. Leurs fonctions pourraient aussi être au moins en partie micro programmées ou micro câblées dans des circuits intégrés dédiés. Ainsi, en variante, le dispositif informatique mettant en oeuvre le système de la figure 3 pourrait être remplacé par un dispositif électronique composé uniquement de circuits numériques (sans programme d'ordinateur) pour la réalisation des mêmes actions.

Il apparaît clairement qu'un procédé de génération de fichiers de modélisation d'un flot de conception de circuit intégré tel que celui décrit précédemment permet une réduction significative du temps de conception d'un PDK client par filtrage d'un PDK de référence complet offrant toute la technologie de connexion tridimensionnelle à la disposition d'un client. En outre, le PDK de référence est réutilisable pour un grand nombre de circuits intégrés dont les contraintes peuvent varier selon un grand nombre de DRM clients. Le PDK de référence est par ailleurs très simple à mettre à jour par l'ajout, la suppression ou la modification de dispositifs de connexion tridimensionnelle de référence. Enfin, le DRM de référence 50 peut être maintenu confidentiel par son concepteur. De même, les dispositifs de référence du PDK de référence 54 qui ne sont pas choisis par le client peuvent être maintenus confidentiels.

On notera par ailleurs que l'invention n'est pas limitée aux modes de réalisation décrits ou mentionnés précédemment. Il apparaîtra en effet à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

## Revendications

1. Procédé de conception d'un circuit intégré à plusieurs couches interconnectées entre elles par des dispositifs de connexion tridimensionnelle souhaités (56), comportant les étapes suivantes :
- fourniture (100, 102) de fichiers de référence (54) modélisant un flot de conception de référence incluant un ensemble prédéterminé (50, 52) de dispositifs de connexion tridimensionnelle (30, 32, 34, 36, 38, 42, 44, 46) et de règles de dessins de référence,
- fourniture (104) d'un manuel (58) de règles de dessins relatives à un flot de conception souhaité du circuit intégré,
- génération (106) de fichiers (60) de modélisation du flot de conception souhaité à partir des fichiers de référence (54) et du manuel (58) de règles de dessins fourni,
**caractérisé en ce que**, les dispositifs de connexion tridimensionnelle souhaités (56) étant tous choisis parmi les dispositifs de connexion tridimensionnelle (30, 32, 34, 36, 38, 42, 44, 46) du flot de conception de référence, l'étape (106) de génération des fichiers (60) de modélisation du flot de conception souhaité comporte un filtrage des fichiers de référence (54) par suppression de toutes données relatives à des dispositifs de connexion tridimensionnelle non choisis et par précision des règles de dessins de référence (50) à l'aide du manuel (58) de règles de dessins fourni,
et **en ce que** le procédé comporte en outre une étape de conception d'un modèle (62) du circuit intégré à partir des fichiers (60) de modélisation générés.

2. Procédé de conception de circuit intégré selon la revendication 1, dans lequel les dispositifs de connexion tridimensionnelle de référence (30, 32, 34, 36, 38, 42, 44, 46) comportent au moins l'un des éléments de l'ensemble constitué de micro-bumps (30), de landing micro bumps (32), de front side UBMs (34), de plots (36), de vias TSV (38), de back side UBMs (42), de pillars (44) et de landing pillars (46).

3. Procédé de conception de circuit intégré selon la revendication 1 ou 2, dans lequel la fourniture (100, 102) de fichiers de référence (54) modélisant un flot de conception de référence comporte la constitution d'un manuel (50) de règles de dessins de référence relatives au flot de conception de référence à partir d'une offre technologique de référence (10) comportant tous les dispositifs de connexion tridimensionnelle de référence (30, 32, 34, 36, 38, 42, 44, 46) et la génération (100), à partir de ce manuel (50) de règles de dessins de référence, d'un fichier (52) descriptif des dispositifs de connexion tridimensionnelle de référence.

4. Procédé de conception de circuit intégré selon la revendication 3, dans lequel les règles de dessins du manuel (50) de règles de dessins de référence sont décrites avec au moins des valeurs minimales, nominales et maximales pour chaque niveau de l'offre technologique de référence (10).

5. Procédé de conception de circuit intégré selon la revendication 4, dans lequel les fichiers de référence (54) modélisant le flot de conception de référence sont constitués à partir du manuel (50) de règles de dessins de référence sur la base des valeurs nominales, en excluant les valeurs minimales et maximales.

6. Procédé de conception de circuit intégré selon l'une quelconque des revendications 1 à 5, dans lequel l'étape (106) de génération des fichiers (60) de modélisation du flot de conception souhaité comporte les six phases suivantes :
- vérification de syntaxe des fichiers de référence (54) modélisant le flot de conception de référence,
- enregistrement de données de description relatives aux dispositifs de connexion tridimensionnelle souhaités et choisis (56),
- interprétation des règles de dessins relatives au flot de conception souhaité,
- constitution des fichiers (60) de modélisation du flot de conception souhaité par filtrage des fichiers de référence (54) modélisant le flot de conception de référence,
- compilation d'un fichier technologique et création d'une bibliothèque logicielle parmi les fichiers (60) de modélisation du flot de conception souhaité, et
- construction d'une arborescence des fichiers (60) de modélisation du flot de conception souhaité.

7. Programme d'ordinateur (70, 74, 80, 86) téléchargeable depuis un réseau de communication et/ou enregistré sur un support lisible par ordinateur et/ou exécutable par un processeur, **caractérisé en ce qu'**il comprend des instructions pour l'exécution des étapes d'un procédé de conception de circuit intégré selon l'une quelconque des revendications 1 à 6, lorsque ledit programme est exécuté sur un ordinateur.

8. Système de conception d'un circuit intégré à plusieurs couches interconnectées entre elles par des dispositifs de connexion tridimensionnelle souhaités (56), comportant :
- des moyens (70) de stockage de fichiers de référence (54) modélisant un flot de conception de référence incluant un ensemble prédéterminé (50, 52) de dispositifs de connexion tridimensionnelle (30, 32, 34, 36, 38, 42, 44, 46) et de règles de dessins de référence,
- des moyens (74 ; 80) de stockage d'un manuel (58) de règles de dessins relatives à un flot de conception souhaité du circuit intégré incluant des dispositifs de connexion tridimensionnelle souhaités (56),
- un processeur ayant accès aux moyens de stockage et générateur de fichiers (60) de modélisation du flot de conception souhaité à partir des fichiers de référence (54) et du manuel (58) de règles de dessins fourni,
**caractérisé en ce que**, les dispositifs de connexion tridimensionnelle souhaités (56) étant tous choisis parmi les dispositifs de connexion tridimensionnelle (30, 32, 34, 36, 38, 42, 44, 46) du flot de conception de référence, le système comporte des moyens (84) de filtrage des fichiers de référence (54) par suppression de toutes données relatives à des dispositifs de connexion tridimensionnelle non choisis et par précision des règles de dessins de référence (50) à l'aide du manuel (58) de règles de dessins fourni, ces moyens de filtrage étant exécutables par le processeur pour la génération des fichiers (60) de modélisation du flot de conception souhaité,
et **en ce que** le système comporte en outre des moyens de conception, exécutables par le processeur, d'un modèle (62) du circuit intégré à partir des fichiers (60) de modélisation générés.

9. Système de conception de circuit intégré selon la revendication 8, comportant une interface de saisie (82), exécutable par le processeur, pour la fourniture par un utilisateur d'au moins une partie des règles de dessins relatives au flot de conception souhaité incluant les dispositifs de connexion tridimensionnelle souhaités (56), cette interface de saisie (82) comportant :
- une zone de sélection de dispositifs de connexion tridimensionnelle souhaités dans l'ensemble prédéterminé de dispositifs de connexion tridimensionnelle (30, 32, 34, 36, 38, 42, 44, 46) du flot de conception de référence,
- une zone de saisie de valeurs de règles de dessins relatives aux dispositifs de connexion tridimensionnelle sélectionnés.

10. Système de conception de circuit intégré selon la revendication 9, dans lequel l'interface de saisie (82) est configurée pour une saisie d'informations issues du manuel (58) de règles de dessins relatives au flot de conception souhaité et le complétant.
